# FASCICULE DE BREVET EUROPEEN

(11) **EP 4 572 089 B1**
(45) Date de publication et mention de la délivrance du brevet: **17.06.2026**
(21) Numéro de dépôt: 24209128.8
(22) Date de dépôt: 28.10.2024
(51) Int. Cl.: H02J 50/20, H04B 5/00

(54) **DISPOSITIF ÉMETTEUR DE CHARGE SANS FIL**
DRAHTLOSE LADESENDERVORRICHTUNG
WIRELESS CHARGING TRANSMITTER DEVICE

(30) Priorité: 06.11.2023 FR 2312033
(43) Date de publication de la demande: 18.06.2025
(73) Titulaire: STMicroelectronics International N.V., 1228 Plan-les-Ouates, Geneva (CH)
(72) Inventeur: LEDUC, Bruno, 38500 Voiron (FR); MONTJAUX, Grégoire, 38640 Claix (FR); GRUNDRICH, Christophe, 38000 Grenoble (FR); DEGOIRAT, Hubert, 38190 Villard Bonnot (FR)
(74) Mandataire: Casalonga

(56) Documents cités:
- EP-A2- 2 450 835
- CN-A- 101 739 542
- KR-B1- 102 353 272
- US-B1- 10 256 661

## Description

Des modes de réalisation concernent les circuits de recharge sans fil, notamment la recharge sans fil utilisant la technologie NFC (acronyme de l'anglais « Near Field Communication »).

La recharge sans fil permet de charger des dispositifs électroniques sans utiliser de branchement physique mais à partir d'un champ magnétique.

La recharge sans fil utilisant la technologie NFC présente l'avantage d'être peu exigeante en termes d'occupation spatiale et permet d'utiliser des antennes sur circuit imprimé.

La recharge sans fil utilisant la technologie NFC permet de réaliser une recharge d'un dispositif électronique sans fil sur une faible distance, par exemple de l'ordre de 10 cm.

La technologie NFC est une plateforme technologique ouverte normalisée dans la norme ISO/IEC 18092 et ISO/IEC 21481 mais incorpore de nombreuses normes déjà existantes comme par exemple les protocoles type A et type B définis dans la norme ISO-14443 qui peuvent être des protocoles de communication utilisables dans la technologie NFC. La recharge sans fil utilisant la technologie NFC est définie par la version 2.0 de la spécification NFC WLC (« WireLess Charging ») publiée en Octobre 2021 par le NFC Forum.

La recharge sans fil NFC permet notamment de charger des dispositifs électroniques relativement petits, tels que des écouteurs sans fils et des montres intelligentes, des dispositifs de suivi de forme physique, ou d'autres dispositifs électroniques de l'Internet des Objets. Par exemple, des dispositifs électroniques peuvent être chargés par recharge sans fil NFC à partir d'un téléphone intelligent ou à partir d'une station de recharge dédiée.

Plus particulièrement, la recharge sans fil NFC repose sur un dispositif émetteur de charge (également désigné par le terme anglais « poller ») et sur un dispositif récepteur de puissance (également désigné par le terme anglais « listener »). Le dispositif émetteur de charge est utilisé pour charger le dispositif récepteur de puissance. Comme indiqué précédemment, le dispositif émetteur de charge peut être un téléphone intelligent ou une station de recharge dédiée par exemple.

La vitesse de la recharge sans fil (notamment NFC) dépend d'une puissance du signal de recharge généré par le dispositif émetteur de charge. Plus la puissance du signal de recharge généré par le dispositif émetteur de charge est élevée, plus la recharge du dispositif récepteur de puissance est rapide. Il est notamment préférable de générer un signal de recharge ayant une puissance relativement élevée comprise entre 1 Watt et 3 Watts.

Afin d'effectuer une recharge du dispositif récepteur de charge, le signal de recharge est généré sur une période relativement longue pendant la durée de vie de l'émetteur de charge, notamment supérieure à 20000 heures (c'est-à-dire 6 heures par jour pendant 10 ans). De ce fait, le signal de recharge peut être générée sur une période de plusieurs années pendant la durée de vie de l'émetteur de charge, alors que la communication NFC est de l'ordre de quelques centaines d'heures.

Néanmoins, le fait de générer un signal de recharge ayant une puissance élevée sur une longue période peut dégrader les composants dudit circuit générateur du signal de recharge du dispositif émetteur de charge. La dégradation de ces composants peut dégrader les performances de la recharge sans fil.

La puissance du signal de recharge est définie par le courant et la tension fournie à l'antenne de l'émetteur de charge. Le courant est défini selon l'impédance de l'antenne et ne peut donc pas être augmenté. En outre, augmenter le courant implique d'augmenter la température générée par le circuit générateur du signal de recharge. Ainsi, afin d'augmenter la puissance du signal de recharge, il convient plutôt d'augmenter la tension fournie à l'antenne de l'émetteur de charge.

Il convient donc d'utiliser des composants supportant des hautes tensions permettant d'augmenter la puissance du signal de recharge. Néanmoins, comme vu précédemment les performances de ces composants peuvent se dégrader au cours du temps.

En particulier, le circuit de génération du signal de recharge comprend un circuit de génération d'un signal carré en différentiel à une fréquence donnée, notamment à 13,56MHz dans le cadre d'une recharge NFC. Le signal carré remis en forme par le filtre d'interférence électromagnétique (en anglais « electromagnic interference (EMI) filters ») correspondant alors au signal de recharge. Ce circuit de génération d'un signal carré comprend des transistors de type « MOSFET » (acronyme de l'anglais « metal-oxide-semiconductor field-effect transistor », c'est-à-dire transistor à effet de champ à structure métal-oxyde-semiconducteur). Ces transistors de type « MOSFET » sont commandés de manière à générer ledit signal carré. Un exemple de générateur de signaux carrés appliqué à un dispositif NFC peut être trouvé dans le document US10256661.

Ces transistors de type « MOSFET » sont généralement conçus pour obtenir une impédance relativement faible en sortie du circuit de génération du signal de recharge. Néanmoins, de tels transistors ne sont pas configurés pour supporter des tensions drain-source élevées, qui peuvent réduire leur durée de vie.

Afin de réduire la perte de performances d'un transistor au cours du temps, il est possible d'augmenter la longueur du canal de ce transistor. Néanmoins, cette solution implique d'augmenter la taille du circuit de génération du signal de recharge.

Il existe donc un besoin de proposer une solution permettant de fournir un signal de recharge ayant une puissance relativement élevée tout en réduisant la baisse de performances au cours du temps du circuit de génération d'un tel signal de recharge.

Selon un aspect, il est proposé un dispositif émetteur de charge sans fil comprenant :
- un circuit de génération configuré pour générer un signal de recharge à une fréquence donnée,
- une antenne configurée pour émettre ledit signal de recharge, le circuit de génération comprenant au moins un circuit d'élaboration d'un signal carré comportant :
   - un premier circuit de commutation à transistors de type PMOS comprenant un groupe de transistors de performances de type PMOS et au moins un transistor de fonctionnalité de type PMOS, ledit au moins un transistor de fonctionnalité de type PMOS présentant une impédance de sortie supérieure à une impédance de sortie des transistors de performances de type PMOS,
   - un deuxième circuit de commutation à transistors de type NMOS comprenant un groupe de transistors de performances de type NMOS et au moins un transistor de fonctionnalité de type NMOS, ledit au moins un transistor de fonctionnalité de type NMOS présentant une impédance de sortie supérieure à une impédance de sortie des transistors de performances de type NMOS.

Les transistors de fonctionnalité de type PMOS et de type NMOS sont utilisés pour assurer les transitions entre un état haut et un état bas du signal de recharge. Ces transistors de fonctionnalité sont configurés pour supporter des tensions drain-source relativement élevées, par exemple de l'ordre de 7,5 Volts.

Les transistors de performances de type PMOS et de type NMOS sont utilisés pour assurer une impédance de sortie du circuit de génération relativement faible.

Dans un mode de réalisation avantageux, les transistors de performances de type PMOS présentent une source configurée pour recevoir une tension d'alimentation, un drain connecté à un drain des transistors de performances de type NMOS, et une grille configurée pour recevoir un premier signal de commande. En outre, les transistors de performances de type NMOS présentent également une source connectée à un point froid et une grille configurée pour recevoir un deuxième signal de commande.

Avantageusement, ledit au moins un transistor de fonctionnalité de type PMOS présente une source configurée pour recevoir une tension d'alimentation, un drain connecté à un drain dudit au moins un transistor de fonctionnalité de type NMOS, et une grille configurée pour recevoir un troisième signal de commande. En outre, ledit au moins un transistor de fonctionnalité de type NMOS présente également une source connectée à un point froid et une grille configurée pour recevoir ledit troisième signal de commande.

Dans un mode de réalisation avantageux, les transistors de performances de type PMOS et les transistors de performances de type NMOS sont commandés en décalé par rapport audit au moins un transistor de fonctionnalité de type PMOS et audit au moins un transistors de fonctionnalité de type NMOS de manière à éviter d'appliquer simultanément une tension drain-source et une tension grille-source supérieures à un seuil de tension défini sur les transistors de performances de type PMOS et sur les transistors de performances de type NMOS.

Le fait de commander de manière décalée les transistors de performances de type PMOS et ceux de type NMOS, par rapport audit au moins un transistor de fonctionnalité de type PMOS et audit au moins un transistor de fonctionnalité de type NMOS, permet de protéger ces transistors de performances des hautes tensions. Il est alors possible d'augmenter la tension drain-source dudit au moins un transistor de fonctionnalité de type PMOS et dudit au moins un transistor de fonctionnalité de type NMOS. En particulier, cette tension drain-source peut être augmentée sur une longue durée sans trop impacter la durée de vie de ces transistors de fonctionnalité. Les transistors de fonctionnalité ont ainsi des longueurs plus grandes par rapport à celles des transistors de performances. Cela leur permet d'être plus robuste au vieillissement et ainsi de maintenir de bonnes performances dans le temps. Cela permet donc d'augmenter la durée de vie de ces transistors de fonctionnalité. Les transistors de performances ont quant à eux des longueurs plus petites de manière à minimiser leur surface d'occupation. Les transistors de fonctionnalité occupent qu'une faible surface par rapport à l'ensemble dudit circuit de génération. Ainsi, bien que les longueurs des transistors de fonctionnalité soient plus grandes que celles des transistors de performances, cela n'entraîne pas une augmentation significative de la surface du circuit de génération.

Avantageusement, le seuil de tension est compris entre 0,4 Volt et 1 Volt.

De préférence, le dispositif émetteur de charge sans fil comprend en outre un circuit de commande configuré pour générer le premier signal de commande, le deuxième signal de commande et le troisième signal de commande.

Avantageusement, le dispositif émetteur de charge sans fil comprend en outre un circuit générateur d'un signal d'horloge initial. En outre, le circuit de commande comporte :
- un premier circuit de délai configuré pour recevoir en entrée ledit signal d'horloge initial et pour générer en sortie un premier signal d'horloge intermédiaire décalé temporellement par rapport au signal d'horloge initial, ledit premier signal d'horloge intermédiaire correspondant au troisième signal de commande
- un deuxième circuit de délai configuré pour recevoir en entrée ledit premier signal d'horloge intermédiaire et pour générer en sortie un deuxième signal d'horloge intermédiaire décalé temporellement par rapport au premier signal d'horloge intermédiaire,
- un premier circuit de sélection de front configuré pour générer le premier signal de commande à partir d'une sélection alternée du signal d'horloge initial et du deuxième signal de d'horloge intermédiaire,
- un deuxième circuit de sélection de front configuré pour générer le deuxième signal de commande à partir d'une sélection alternée du signal d'horloge initial et du deuxième signal d'horloge intermédiaire, cette sélection étant inversée par rapport à celle du premier circuit de sélection de front.

De préférence, les transistors de performances de type NMOS présentent une impédance de sortie comprise entre 0,5 ohm et 1 ohm.

Avantageusement, les transistors de performances de type NMOS présentent une longueur de canal supérieure ou égale à 0,72 micromètre.

De préférence, les transistors de performances de type PMOS présentent une impédance de sortie comprise entre 0,5 ohm et 1 ohm.

Avantageusement, les transistors de performances de type PMOS présentent une longueur de canal supérieure ou égale à 0,72 micromètre.

De préférence, ledit au moins un transistor de fonctionnalité de type NMOS présente une impédance de sortie comprise entre 5 ohms et 10 ohms.

Avantageusement, ledit au moins un transistor de fonctionnalité de type NMOS présente une longueur de canal supérieure ou égale à 1,44 micromètre, notamment deux à trois fois plus long que la longueur de canal des transistors de performances de type NMOS.

De préférence, ledit au moins un transistor de fonctionnalité de type PMOS présente une impédance de sortie comprise entre 5 ohms et 10 ohms.

Avantageusement, ledit au moins un transistor de fonctionnalité de type PMOS présente une longueur de canal supérieure ou égale à 1,44 micromètre, notamment deux à trois fois plus long que la longueur de canal des transistors de performances de type PMOS.

D'autres avantages et caractéristiques de l'invention apparaîtront à l'examen de la description détaillée de modes de réalisation, nullement limitatifs, et des dessins annexés sur lesquels :
[Fig 1]
[Fig 2]
[Fig 3]
[Fig 4]

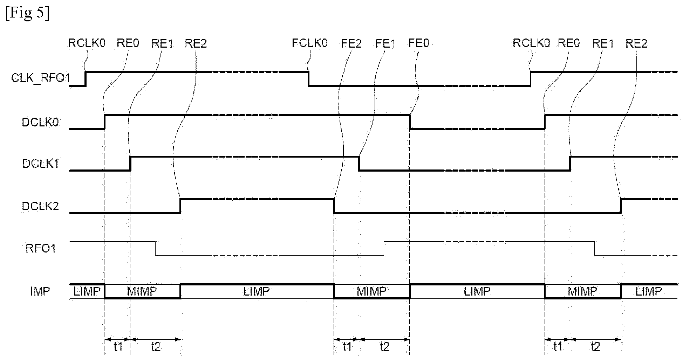

[Fig 5] illustrent des modes de réalisation et de mise en œuvre de l'invention.

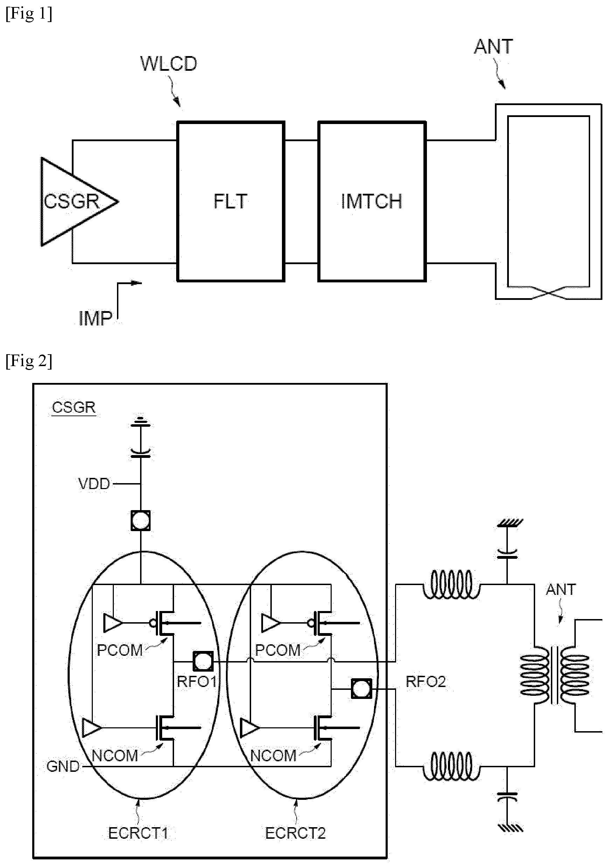

La figure 1 illustre un mode de réalisation d'un dispositif émetteur de charge sans fil WLCD.

Le dispositif émetteur de charge WLCD comprend une source d'alimentation (non représentée), un circuit CGSR de génération d'un signal de recharge, un filtre d'interférence électromagnétique FLT, un circuit d'adaptation d'impédance IMTCH, et une antenne ANT.

La source d'alimentation peut être une batterie par exemple.

Le circuit CSGR de génération du signal de recharge est configuré pour générer un signal de recharge à partir de la source d'alimentation. Le signal de recharge est composé de deux signaux carrés en opposition de phase. Ces signaux carrés sont transmis à l'antenne ANT via le filtre d'interférence électromagnétique FLT puis le circuit d'adaptation d'impédance IMTCH.

Le filtre d'interférence électromagnétique FLT est un circuit configuré pour atténuer, voire supprimer, des interférences électromagnétiques dans les signaux carrés générés par le circuit CSGR de génération du signal de recharge.

Le circuit d'adaptation d'impédance IMTCH est configuré pour adapter l'impédance vue par l'antenne ANT.

L'antenne ANT est configurée pour émettre le signal de recharge généré par le circuit CSGR de génération du signal de recharge.

Un tel signal de recharge peut être reçu par un dispositif LST récepteur de charge de manière à pouvoir recharger sans fil une batterie du dispositif LST récepteur de charge.

La figure 2 illustre un mode de réalisation d'un circuit CSGR de génération d'un signal de recharge tel que décrit précédemment. Le circuit CSGR de génération comprend deux circuits ECRCT1, ECRCT2 d'élaboration d'un signal carré fonctionnant en opposition de phase. Les circuits ECRT1 et ECRCT2 sont configurés pour générer respectivement les signaux carrés RFO1 et RFO2 en opposition de phase. Ces signaux carrés RFO1 et RFO2 forment le signal de recharge qui est ensuite émis par l'antenne ANT sous une forme sinusoïdale après filtrage.

Chaque circuit ECRCT1, ECRCT2 correspond à un circuit d'une chaîne d'inverseur. Ainsi, chaque circuit ECRCT1, ECRCT2 d'élaboration d'un signal carré comprend un circuit PCOM de commutation à transistors de type PMOS et un circuit NCOM de commutation à transistors de type NMOS. Les transistors de type PMOS sont des transistors à effet de champ à grille isolée (désigné également par l'acronyme « MOSFET » de l'anglais « metal-oxide-semiconductor field-effect transistor ») de type P. Les transistors de type NMOS sont des transistors à effet de champ à grille isolée de type N.

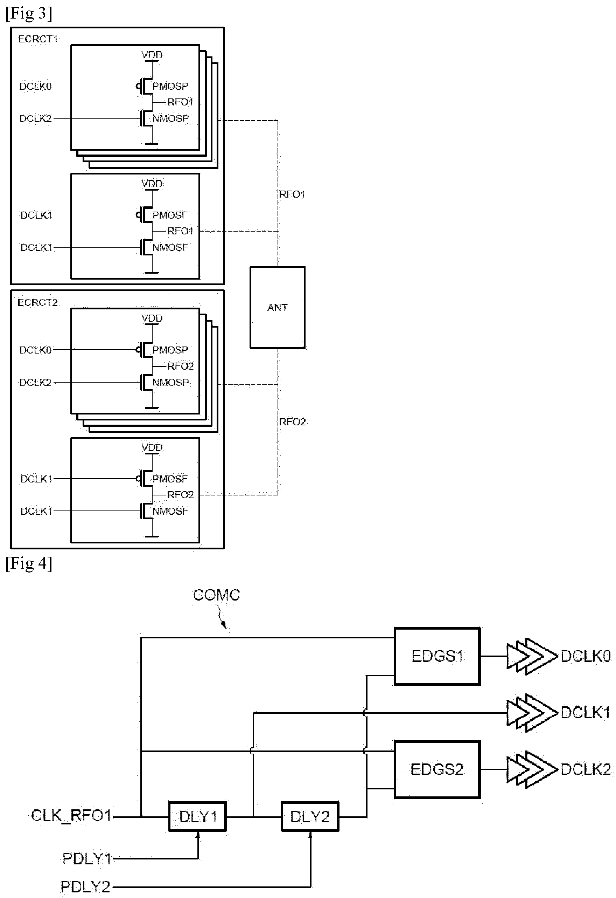

La figure 3 illustre un mode de réalisation du dernier étage de ces circuits ECRCT1 et ECRCT2.

En particulier, le circuit PCOM de commutation à transistors de type PMOS comporte un premier groupe de transistors de type PMOS, dits transistors PMOSP de performances, et un transistor de type PMOS, dit transistor PMOSF de fonctionnalité.

En particulier, le transistor PMOSF de fonctionnalité est utilisé pour assurer la transition entre un état bas et un état haut du signal de recharge. Le transistor PMOSF de fonctionnalité présente une impédance de sortie relativement élevée. Par exemple, le transistor PMOSF de fonctionnalité présente une impédance de sortie comprise entre 5 ohms et 10 ohms, par exemple de l'ordre de 8 ohms. Afin d'obtenir une telle impédance de sortie, le transistor PMOSF de fonctionnalité présente une longueur de canal supérieure ou égale à 1,44 micromètre.

Les transistors PMOSP de performances sont configurés pour améliorer les performances du circuit de commutation. Les transistors PMOS de performances présentent une impédance de sortie relativement faible. Par exemple, les transistors PMOSP de performances présentent une impédance de sortie comprise entre 0,5 ohm et 1 ohm, par exemple de l'ordre de 0,5 ohm. Afin d'obtenir une telle impédance de sortie, chaque transistor PMOSP de performances présente une longueur de canal supérieure ou égale à 0,72 micromètre, notamment deux à trois fois plus petite que la longueur de canal du transistors PMOSF de fonctionnalité.

Le circuit de commutation à transistors de type NMOS comporte un premier groupe de transistors de type NMOS, dits transistors NMOSP de performances, et au moins un autre transistor de type NMOS, dit transistor NMOSF de fonctionnalité.

En particulier, un transistor NMOSF de fonctionnalité est également utilisé pour assurer une transition entre un état haut et un état bas du signal de recharge. Le transistor NMOSF de fonctionnalité présente une impédance de sortie relativement élevée. Par exemple, le transistor NMOSF de fonctionnalité présente une impédance de sortie comprise entre 5 ohms et 10 ohms, par exemple de l'ordre de 8 ohms. Afin d'obtenir une telle impédance de sortie, le transistor NMOSF de fonctionnalité présente une longueur de canal supérieure ou égale à 1,44 micromètre.

Les transistors NMOSP de performances sont configurés pour améliorer les performances du circuit de commutation. Les transistors NMOSP de performances présentent une impédance de sortie relativement faible. Par exemple, les transistors NMOSP de performances présentent une impédance de sortie comprise entre 0,5 ohm et 1 ohm, par exemple de l'ordre de 0,5 ohm. Afin d'obtenir une telle impédance de sortie, chaque transistor NMOSP de performances présente une longueur de canal comprise supérieure ou égale à 0,72 micromètre, notamment deux à trois fois plus petite que la longueur de canal du transistors PMOSF de fonctionnalité.

Le transistor PMOSF de fonctionnalité et le transistor NMOSF de fonctionnalité sont configurés pour être commutés en décalé par rapport aux transistors PMOSP de performances et aux transistors NMOSP de performances. De la sorte, le transistor PMOSF de fonctionnalité et le transistor NMOSF de fonctionnalité peuvent subir simultanément des tensions drain-source et des tensions grille-source élevées. Néanmoins, le transistor PMOSF de fonctionnalité et le transistor NMOSF de fonctionnalité sont configurés pour supporter de telles tensions élevées. En effet, le transistor PMOSF de fonctionnalité et le transistor NMOSF de fonctionnalité ont une taille de grille plus importante pour supporter le vieillissement.

Le transistor PMOSF de fonctionnalité présente une source, un drain et une grille. La source de ce transistor PMOSF de fonctionnalité est connectée à une source d'alimentation VDD. La grille de ce transistor PMOSF de fonctionnalité est configurée pour recevoir un signal DCLK1.

Le transistor NMOSF de fonctionnalité présente une source, un drain et une grille. Le drain du transistor NMOSF de fonctionnalité est connecté au drain d'un transistor PMOSF de fonctionnalité. Le drain de chaque transistor NMOSF de fonctionnalité est connecté au drain de ce transistor PMOSF de fonctionnalité. La source de ce transistor NMOSF de fonctionnalité est connectée à un point froid, notamment à une masse GND. La grille de ce transistor NMOSF de fonctionnalité est configurée pour recevoir le signal DCLK1.

Les transistors PMOSP de performances et les transistors NMOSP de performances sont configurés pour être commutés en décalé par rapport au transistor PMOSF de fonctionnalité et au transistor NMOSF de fonctionnalité. De la sorte, les transistors PMOSP de performances et les transistors NMOSP de performances ne subissent pas simultanément des tensions drain-source et des tensions grille-source élevées. Cela permet d'éviter des conditions de fonctionnement pouvant entraîner une injection de porteur chaud pouvant dégrader les transistors PMOSP de performances et les transistors NMOSP de performances.

Le transistor PMOSP de performances présente une source, un drain et une grille. La source de ce transistor PMOSP de performances est connectée à la source d'alimentation VDD. La grille de ce transistor PMOS de performances est configurée pour recevoir un signal DCLK0.

Le transistor NMOSP de performances présente une source, un drain et une grille. Le drain de chaque transistor NMOSP de performances est connecté au drain d'un transistor PMOSP de performances. La source de ce transistor NMOSP de performances est connectée à un point froid, notamment à la masse GND. La grille de ce transistor NMOSP de performances est configurée pour recevoir un signal DCLK2.

Le circuit de génération du signal de recharge comprend également un circuit de commande COMC. Ce circuit de commande COMC est configuré pour commander les transistors PMOSP, PMOSF et NMOSP, NMOSF des circuits de commutation PCOM, NCOM.

La figure 4 illustre un mode de réalisation d'un tel circuit de commande COMC. Le circuit de commande COMC est configuré pour recevoir un signal d'horloge CLK_RFO1. Ce signal d'horloge CLK_RFO1 peut être fourni par un oscillateur radiofréquence du dispositif émetteur de charge sans fil WLCD. L'oscillateur radiofréquence peut comprendre une boucle à verrouillage de phase.

Le circuit de commande COMC comprend un premier circuit de délai DLY1. Ce premier circuit de délai DLY1 est configuré pour recevoir le signal d'horloge CLK_RFO1 et pour générer un signal DCLK1 décalé d'une durée t1 par rapport au signal d'horloge CLK_RFO1. La durée t1 peut être ajustée via un premier signal numérique de contrôle PDLY1. La durée t1 peut être comprise entre 0,5 nanoseconde et 10 nanosecondes.

Le circuit de commande comprend un deuxième circuit de délai DLY2. Le deuxième circuit de délai DLY2 est configuré pour recevoir le signal DCLK1 et pour générer un signal TCLK2 décalé d'une durée t2 par rapport au signal DCLK1, et de la somme des durées t1 et t2 par rapport au signal d'horloge CLK_RFO1. La durée t2 peut être ajustée via un signal numérique de contrôle PDLY2. La durée t2 peut être comprise entre 0,5 nanoseconde et 10 nanosecondes.

Comme cela est décrit dans la suite, la durée t1 permet d'éviter une conduction croisée entre les transistors PMOSP, NMOSP de performances et les transistors PMOSF, NMOSF de fonctionnalité de chaque circuit ECRCT d'élaboration d'un signal carré. La durée t2 permet d'améliorer la durée de vie des transistors PMOSP, NMOSP de performances et les transistors PMOSF, NMOSF de fonctionnalité chaque circuit d'élaboration d'un signal carré en évitant de fournir simultanément une tension drain-source et une tension grille-source relativement élevée.

Le circuit de commande comprend également un premier circuit de sélection de front EDGS1. Le premier circuit de sélection de front est configuré pour recevoir le signal d'horloge CLK_RFO1 et le signal TCLK2. Le premier circuit de sélection de front EDGS1 est configuré pour délivrer en sortie un signal DCLK0 correspondant soit au signal d'horloge CLK_RFO1 soit au signal TCLK2. En particulier, le premier circuit de sélection de front EDGS1 comporte un ensemble de portes logiques permettant de générer le signal DCLK0.

Le circuit de commande comprend également un deuxième circuit de sélection de front EDGS2. Le deuxième circuit de sélection de front EDGS2 est configuré pour recevoir le signal d'horloge CLK_RFO1 et le signal TCLK2. Le deuxième circuit de sélection de front EDGS2 est configuré pour délivrer en sortie un signal DCLK2 correspondant soit au signal d'horloge CLK_RFO1 soit au signal TCLK2. En particulier, le deuxième circuit de sélection de front EDGS2 comporte un ensemble de portes logiques permettant de générer le signal DCLK2.

Le circuit de commande comprend un premier circuit tampon BUF0. Le premier circuit tampon est configuré pour recevoir le signal DCLK0 non bufferisé et pour délivrer ce signal DCLK0 bufferisé sur la grille des transistors PMOS de performances.

Le circuit de commande comprend un deuxième circuit tampon BUF1. Le deuxième circuit tampon est configuré pour recevoir le signal DCLK1 non bufferisé et pour délivrer ce signal DCLK1 bufferisé sur la grille du transistor PMOSF de fonctionnalité et sur la grille du transistor NMOSF de fonctionnalité.

Le circuit de commande comprend un troisième circuit tampon BUF2. Le troisième circuit tampon est configuré pour recevoir le signal DCLK2 non bufferisé et pour délivrer ce signal DCLK2 bufferisé sur la grille des transistors NMOSP de performances.

Le circuit de commande génère donc trois signaux de commande DCLK0, DCLK1 et DCLK2. Le signal DCLK0 est utilisé pour commander les transistors PMOSP de performances. Le signal DCLK1 est utilisé pour commander le transistor PMOSF de fonctionnalité et pour commander le transistor NMOSF de fonctionnalité. Le signal DCLK2 est utilisé pour commander les transistors NMOSP de performances.

La figure 5 montre les signaux DCLK0, DCLK1 et DCLK2 ainsi qu'un signal carré généré par un circuit d'élaboration de signal carré pendant un cycle d'horloge.

Comme illustré sur cette figure 5, sur chaque cycle d'horloge CLK_RFO1, le circuit de commande est configuré pour générer un signal DCLK0 ayant :
- un front descendant FE0 retardé de ladite durée t2 par rapport à un front descendant FE1 du signal DCLK1 et retardé de la somme des durées t1 et t2 par rapport à un front descendant FE2 du signal DCLK2 (le signal DCLK0 étant alors généré en sélectionnant le front descendant du signal TCLK2, et le signal DCLK2 étant alors généré en sélectionnant le front descendant FCLK0 du signal CLK_RFO1) ,
- un front montant RE0 avancé de ladite durée t1 par rapport à un front montant RE1 du signal DLCK1 et avancé de la somme des durées t1 et t2 par rapport à un front montant RE2 du signal DCLK2 (le signal DCLK0 étant alors généré en sélectionnant le front montant RCLK0 du signal CLK_RFO1, et le signal DCLK2 étant alors généré en sélectionnant le front montant du signal TCLK2).

Ainsi, avant le front descendant FE2 du signal DCLK2, l'impédance IMP de sortie du circuit d'élaboration du signal carré correspond à l'impédance de sortie des transistors de performances et est donc une impédance relativement faible LIMP. Entre le front descendant FE2 du signal DCLK2 et le front descendant FE0 du signal DCLK0, l'impédance IMP de sortie du circuit d'élaboration du signal carré correspond à une impédance intermédiaire MIMP entre l'impédance de sortie des transistors de fonctionnalité et l'impédance de sortie des transistors de performances. Entre le front descendant FE0 du signal DCLK0 et le front montant RE0 du signal DCLK0, l'impédance IMP de sortie du circuit d'élaboration du signal carré correspond à l'impédance de sortie des transistors de performances et est donc une impédance relativement faible LIMP. Entre le front montant RE0 du signal DCLK0 et le front montant RE2 du signal DCLK2, l'impédance IMP de sortie du circuit d'élaboration du signal carré correspond à une impédance intermédiaire MIMP entre l'impédance de sortie des transistors de fonctionnalité et l'impédance de sortie des transistors de performances. Après le front montant RE2 du signal DCLK2, l'impédance IMP de sortie du circuit d'élaboration du signal carré correspond à l'impédance de sortie des transistors de performances et est donc une impédance relativement faible LIMP.

De la sorte, le transistor PMOSF de fonctionnalité et le transistor NMOSF de fonctionnalité sont configurés pour recevoir simultanément une tension drain-source et une tension grille-source relativement élevée. Ainsi, le transistor PMOSF de fonctionnalité et le transistor NMOSF de fonctionnalité peuvent fonctionner dans des conditions pouvant entraîner une injection de porteur chaud. Néanmoins, le transistor PMOSF de fonctionnalité et le transistor NMOSF de fonctionnalité sont configurés pour supporter ces conditions de fonctionnement. En effet, ces transistors NMOSF, PMOSF de fonctionnalité présentent une taille de grille suffisamment élevée pour supporter ces conditions de fonctionnement.

Les transistors PMOSP de performances et les transistors NMOSP de performances sont configurés pour éviter de recevoir simultanément une tension drain-source et une tension grille-source relativement élevée. Ainsi, les transistors PMOSP de performances et les transistors NMOSP de performances évitent de fonctionner dans des conditions pouvant entraîner une injection de porteur chaud. Il est donc possible d'utiliser des transistors de performances ayant une impédance de sortie relativement faible. Cela permet d'utiliser des transistors NMOSP, PMOSP de performances de longueurs réduites par rapport aux transistors NMOSF, PMOSF de fonctionnalité.

De la sorte, il est possible d'augmenter la tension du signal de recharge généré par le circuit CSGR. Ainsi, il est possible d'émettre un signal de recharge ayant une puissance relativement élevée, par exemple comprise entre 1 Watt et 3 Watts. Une telle puissance peut donc être obtenue avec un circuit de génération de signal de charge présentant des transistors ayant en moyenne des longueurs de canal relativement petites. En effet, dans un tel circuit de génération, seuls les transistors NMOSF, PMOSF de fonctionnalité ont une longueur de canal suffisamment grande pour supporter simultanément une tension grille-source et une tension drain-source relativement élevée, les transistors NMOSP, PMOSP de performances ayant une longueur de canal plus réduite.

## Revendications

1. Dispositif émetteur de charge sans fil comprenant :
- un circuit (CSGR) de génération configuré pour générer un signal de recharge à une fréquence donnée,
- une antenne configurée pour émettre ledit signal de recharge, le circuit (CSGR) de génération comprenant au moins un circuit (ECRCT1, ECRT2) d'élaboration d'un signal carré comportant :
• un premier circuit de commutation (PCOM) à transistors de type PMOS comprenant un groupe de transistors (PMOSP) de performances de type PMOS et au moins un transistor (PMOSF) de fonctionnalité de type PMOS, ledit au moins un transistor (PMOSF) de fonctionnalité de type PMOS présentant une impédance de sortie supérieure à une impédance de sortie des transistors (PMOSP) de performances de type PMOS,
• un deuxième circuit de commutation (NCOM) à transistors de type NMOS comprenant un groupe de transistors (NMOSP) de performances de type NMOS et au moins un transistor (NMOSF) de fonctionnalité de type NMOS, ledit au moins un transistor (NMOSF) de fonctionnalité de type NMOS présentant une impédance de sortie supérieure à une impédance de sortie des transistors (NMOSP) de performances de type NMOS.

2. Dispositif selon la revendication 1, dans lequel les transistors de performances de type PMOS présentent une source configurée pour recevoir une tension d'alimentation, un drain connecté à un drain des transistors de performances de type NMOS, et une grille configurée pour recevoir un premier signal de commande (DCLK0), et les transistors de performances de type NMOS présentent également une source connectée à un point froid et une grille configurée pour recevoir un deuxième signal de commande (DCLK2).

3. Dispositif selon la revendication 2, dans lequel ledit au moins un transistor de fonctionnalité de type PMOS présente une source configurée pour recevoir une tension d'alimentation, un drain connecté à un drain dudit au moins un transistor de fonctionnalité de type NMOS, et une grille configurée pour recevoir un troisième signal de commande (DCLK1), et ledit au moins un transistor de fonctionnalité de type NMOS présente également une source connectée à un point froid et une grille configurée pour recevoir ledit troisième signal de commande (DCLK1).

4. Dispositif selon la revendication 3, dans lequel les transistors (PMOSP) de performances de type PMOS et les transistors (NMOSP) de performances de type NMOS sont commandés en décalé par rapport audit au moins un transistor (PMOSF) de fonctionnalité de type PMOS et audit au moins un transistors (NMOSF) de fonctionnalité de type NMOS de manière à éviter d'appliquer simultanément une tension drain-source et une tension grille-source supérieures à au moins un seuil de tension défini sur les transistors (PMOSP) de performances de type PMOS et sur les transistors (NMOSP) de performances de type NMOS.

5. Dispositif selon la revendication 4 dans lequel le seuil de tension est compris entre 0,4 Volt et 1 Volt.

6. Dispositif selon l'une des revendications 3 à 5, comprenant en outre un circuit de commande (COMC) configuré pour générer le premier signal de commande (DCLK0), le deuxième signal de commande (DCLK2) et le troisième signal de commande (DCLK1).

7. Dispositif selon la revendication 6, comprenant en outre un circuit générateur d'un signal d'horloge initial (CLK_RFO1), et dans lequel le circuit de commande comporte :
- un premier circuit de délai (DLY1) configuré pour recevoir en entrée ledit signal d'horloge initial et pour générer en sortie un premier signal d'horloge intermédiaire décalé temporellement par rapport au signal d'horloge initial (CLK_RFO1), ledit premier signal d'horloge intermédiaire correspondant au troisième signal de commande (DCLK1)
- un deuxième circuit de délai (DLY2) configuré pour recevoir en entrée ledit premier signal d'horloge intermédiaire et pour générer en sortie un deuxième signal d'horloge intermédiaire (TCLK2) décalé temporellement par rapport au premier signal d'horloge intermédiaire,
- un premier circuit de sélection de front (EDGS1) configuré pour générer le premier signal de commande (DCLK0) à partir d'une sélection alternée du signal d'horloge initial (CLK_RFO1) et du deuxième signal de d'horloge intermédiaire (TCLK2),
- un deuxième circuit de sélection de front (EDG2) configuré pour générer le deuxième signal de commande (DCLK2) à partir d'une sélection alternée du signal d'horloge initial (CLK_RFO1) et du deuxième signal d'horloge intermédiaire (TCLK2), cette sélection étant inversée par rapport à celle du premier circuit de sélection de front.

8. Dispositif selon l'une des revendications 1 à 7, dans lequel les transistors (NMOSP) de performances de type NMOS présentent une impédance de sortie comprise entre 0,5 ohm et 1 ohm.

9. Dispositif selon la revendication 8, dans lequel les transistors (NMOSP) de performances de type NMOS présentent une longueur de canal supérieure ou égale à 0,72 micromètre.

10. Dispositif selon l'une des revendications 1 à 9, dans lequel les transistors (PMOSP) de performances de type PMOS présentent une impédance de sortie comprise entre 0,5 ohm et 1 ohm.

11. Dispositif selon la revendication 10, dans lequel les transistors (PMOSP) de performances de type PMOS présentent une longueur de canal supérieure ou égale à 0,72 micromètre.

12. Dispositif selon l'une des revendications 1 à 11, dans lequel ledit au moins un transistor (NMOSF) de fonctionnalité de type NMOS présente une impédance de sortie comprise entre 5 ohms et 10 ohms.

13. Dispositif selon la revendication 12, dans lequel ledit au moins un transistor (NMOSF) de fonctionnalité de type NMOS présente une longueur de canal supérieure ou égale à 1,44 micromètre.

14. Dispositif selon l'une des revendications 1 à 13, dans lequel ledit au moins un transistor (PMOSF) de fonctionnalité de type PMOS présente une impédance de sortie comprise entre 5 ohms et 10 ohms.

15. Dispositif selon la revendication 14, dans lequel ledit au moins un transistor (PMOSF) de fonctionnalité de type PMOS présente une longueur de canal supérieure ou égale à 1,44 micromètre.

## Patentansprüche

1. Drahtlose Ladesendevorrichtung, die Folgendes umfasst:
- eine Erzeugungsschaltung (CSGR), die so konfiguriert ist, dass sie ein Ladesignal mit einer bestimmten Frequenz erzeugt,
- eine Antenne, die so konfiguriert ist, dass sie das Ladesignal sendet, wobei die Erzeugungsschaltung (CSGR) mindestens eine Schaltung (ECRCT1, ECRT2) zur Erstellung eines Rechtecksignals umfasst, die Folgendes aufweist:
• einen ersten Schaltkreis (PCOM) mit Transistoren vom PMOS-Typ, der eine Gruppe von PMOS-Performance-Transistoren (PMOSP) und mindestens einen PMOS-Funktionstransistor (PMOSF) umfasst, wobei der mindestens eine PMOS-Funktionstransistor (PMOSF) eine Ausgangsimpedanz aufweist, die größer ist als eine Ausgangsimpedanz der PMOS-Performance-Transistoren (PMOSP),
• einen zweiten Schaltkreis (NCOM) mit Transistoren vom NMOS-Typ, der eine Gruppe von NMOS-Performance-Transistoren (NMOSP) und mindestens einen NMOS-Funktionstransistor (NMOSF) umfasst, wobei der mindestens eine NMOS-Funktionstransistor (NMOSF) eine Ausgangsimpedanz aufweist, die größer ist als eine Ausgangsimpedanz der NMOS-Performance-Transistoren (NMOSP) .

2. Vorrichtung nach Anspruch 1, wobei die PMOS-Performance-Transistoren eine Source, die so konfiguriert ist, dass sie eine Versorgungsspannung empfängt, einen Drain, der mit einem Drain der NMOS-Performance-Transistoren verbunden ist, und ein Gate aufweisen, das so konfiguriert ist, dass es ein erstes Steuersignal (DCLK0) empfängt, und die NMOS-Performance-Transistoren auch eine Source, die mit einem Kaltpunkt verbunden ist, und ein Gate aufweisen, das so konfiguriert ist, dass es ein zweites Steuersignal (DCLK2) empfängt.

3. Vorrichtung nach Anspruch 2, wobei der mindestens eine PMOS-Funktionstransistor eine Source, die so konfiguriert ist, dass sie eine Versorgungsspannung empfängt, einen Drain, der so konfiguriert ist, dass er mit einem Drain des mindestens einen NMOS-Funktionstransistors verbunden ist, und ein Gate aufweist, das so konfiguriert ist, dass es ein drittes Steuersignal (DCLK1) empfängt, und der mindestens eine NMOS-Funktionstransistor auch eine Source, die mit einem Kaltpunkt verbunden ist, und ein Gate aufweist, das so konfiguriert ist, dass es das dritte Steuersignal (DCLK1) empfängt.

4. Vorrichtung nach Anspruch 3, wobei die PMOS-Performance-Transistoren (PMOSP) und die NMOS-Performance-Transistoren (NMOSP) im Verhältnis zu dem mindestens einen PMOS-Funktionstransistor (PMOSF) und dem mindestens einen NMOS-Funktionstransistor (NMOSF) versetzt gesteuert werden, um zu vermeiden, dass gleichzeitig eine Drain-Source-Spannung und eine Gate-Source-Spannung anliegen, die größer sind als mindestens eine definierte Spannungsschwelle an den PMOS-Performance-Transistoren (PMOSP) und an den NMOS-Performance-Transistoren (NMOSP).

5. Vorrichtung nach Anspruch 4, wobei die Spannungsschwelle zwischen 0,4 Volt und 1 Volt liegt.

6. Vorrichtung nach einem der Ansprüche 3 bis 5, die ferner eine Steuerschaltung (COMC) umfasst, die so konfiguriert ist, dass sie das erste Steuersignal (DCLK0), das zweite Steuersignal (DCLK2) und das dritte Steuersignal (DCLK1) erzeugt.

7. Vorrichtung nach Anspruch 6, die ferner eine Schaltung zur Erzeugung eines anfänglichen Taktsignals (CLK_RFO1) umfasst, und wobei die Steuerschaltung Folgendes umfasst:
- eine erste Verzögerungsschaltung (DLY1), die so konfiguriert ist, dass sie das anfängliche Taktsignal als Eingang empfängt und ein erstes, zeitlich im Verhältnis zu dem anfänglichen Taktsignal (CLK_RFO1) versetztes Zwischentaktsignal als Ausgang erzeugt, wobei das erste Zwischentaktsignal dem dritten Steuersignal (DCLK1) entspricht
- eine zweite Verzögerungsschaltung (DLY2), die so konfiguriert ist, dass sie das erste Zwischentaktsignal als Eingang empfängt und ein zweites, zeitlich im Verhältnis zu dem ersten Zwischentaktsignal versetztes Zwischentaktsignal (TCLK2) als Ausgang erzeugt,
- eine erste Flankenauswahlschaltung (EDGS1), die so konfiguriert ist, dass sie das erste Steuersignal (DCLK0) anhand einer abwechselnden Auswahl des anfänglichen Taktsignals (CLK_RFO1) und des zweiten Zwischentaktsignals (TCLK2) erzeugt,
- eine zweite Flankenauswahlschaltung (EDG2), die so konfiguriert ist, dass sie das zweite Steuersignal (DCLK2) anhand einer abwechselnden Auswahl des anfänglichen Taktsignals (CLK_RFO1) und des zweiten Zwischentaktsignals (TCLK2) erzeugt, wobei diese Auswahl im Verhältnis zu derjenigen der ersten Flankenauswahlschaltung umgekehrt ist.

8. Vorrichtung nach einem der Ansprüche 1 bis 7, wobei die NMOS-Performance-Transistoren (NMOSP) eine Ausgangsimpedanz zwischen 0,5 Ohm und 1 Ohm aufweisen.

9. Vorrichtung nach Anspruch 8, wobei die NMOS-Performance-Transistoren (NMOSP) eine Kanallänge von 0,72 Mikrometer oder mehr aufweisen.

10. Vorrichtung nach einem der Ansprüche 1 bis 9, wobei die PMOS-Performance-Transistoren (PMOSP) eine Ausgangsimpedanz zwischen 0,5 Ohm und 1 Ohm aufweisen.

11. Vorrichtung nach Anspruch 10, wobei die PMOS-Performance-Transistoren (PMOSP) eine Kanallänge von 0,72 Mikrometer oder mehr aufweisen.

12. Vorrichtung nach einem der Ansprüche 1 bis 11, wobei der mindestens eine NMOS-Funktionstransistor (NMOSF) eine Ausgangsimpedanz zwischen 5 Ohm und 10 Ohm aufweist.

13. Vorrichtung nach Anspruch 12, wobei der mindestens eine NMOS-Funktionstransistor (NMOSF) eine Kanallänge von 1,44 Mikrometer oder mehr aufweist.

14. Vorrichtung nach einem der Ansprüche 1 bis 13, wobei der mindestens eine PMOS-Funktionstransistor (PMOSF) eine Ausgangsimpedanz zwischen 5 Ohm und 10 Ohm aufweist.

15. Vorrichtung nach Anspruch 14, wobei der mindestens eine PMOS-Funktionstransistor (PMOSF) eine Kanallänge von 1,44 Mikrometer oder mehr aufweist.

## Claims

1. Wireless charging transmitter device comprising:
- a generation circuit (CSGR) configured to generate a charging signal at a given frequency,
- an antenna configured to emit said charging signal, the generation circuit (CSGR) comprising at least one circuit (ECRCT1, ECRT2) for generating a square signal comprising:
• a first PMOS transistor switching circuit (PCOM) comprising a group of PMOS performance transistors (PMOSP) and at least one PMOS functionality transistor (PMOSF), said at least one PMOS functionality transistor (PMOSF) having an output impedance higher than an output impedance of the PMOS performance transistors (PMOSP),
• a second NMOS transistor switching circuit (NCOM) comprising a group of NMOS performance transistors (NMOSP) and at least one NMOS functionality transistor (NMOSF), said at least one NMOS functionality transistor (NMOSF) having an output impedance higher than an output impedance of the NMOS performance transistors (NMOSP).

2. Device according to claim 1, wherein the PMOS performance transistors have a source configured to receive a power supply voltage, a drain connected to a drain of the NMOS performance transistors, and a gate configured to receive a first control signal (DCLK0), and the NMOS performance transistors also have a source connected to a cold point and a gate configured to receive a second control signal (DCLK2).

3. Device according to claim 2, wherein said at least one PMOS functionality transistor has a source configured to receive a power supply voltage, a drain connected to a drain of said at least one NMOS functionality transistor, and a gate configured to receive a third control signal (DCLK1), and said at least one NMOS functionality transistor also has a source connected to a cold point and a gate configured to receive said third control signal (DCLK1).

4. Device according to claim 3, wherein the PMOS performance transistors (PMOSP) and the NMOS performance transistors (NMOSP) are controlled in a staggered manner in relation to said at least one PMOS functionality transistor (PMOSF) and to said at least one NMOS functionality transistor (NMOSF) so as to prevent simultaneously applying a drain-source voltage and a gate-source voltage greater than at least one voltage threshold defined on the PMOS performance transistors (PMOSP) and on the NMOS performance transistors (NMOSP).

5. Device according to claim 4, wherein the voltage threshold is between 0.4 Volt and 1 Volt.

6. Device according to one of claims 3 to 5, further comprising a control circuit (COMC) configured to generate the first control signal (DCLK0), the second control signal (DCLK2) and the third control signal (DCLK1).

7. Device according to claim 6, further comprising a circuit for generating an initial clock signal (CLK_RFO1), and wherein the control circuit comprises:
- a first delay circuit (DLY1) configured to receive as input said initial clock signal and to generate as output a first intermediate clock signal temporally offset in relation to the initial clock signal (CLK_RFO1), said first intermediate clock signal corresponding to the third control signal (DCLK1),
- a second delay circuit (DLY2) configured to receive as input said first intermediate clock signal and to generate as output a second intermediate clock signal (TCLK2) temporally offset in relation to the first intermediate clock signal,
- a first edge selection circuit (EDGS1) configured to generate the first control signal (DCLK0) from an alternating selection of the initial clock signal (CLK_RFO1) and of the second intermediate clock signal (TCLK2),
- a second edge selection circuit (EDG2) configured to generate the second control signal (DCLK2) from an alternating selection of the initial clock signal (CLK_RFO1) and of the second intermediate clock signal (TCLK2), this selection being inverted in relation to the first edge selection circuit.

8. Device according to one of claims 1 to 7, wherein the NMOS performance transistors (NMOSP) have an output impedance between 0.5 Ohm and 1 Ohm.

9. Device according to claim 8, wherein the NMOS performance transistors (NMOSP) have a channel length greater than or equal to 0.72 micrometres.

10. Device according to one of claims 1 to 9, wherein the PMOS performance transistors (PMOSP) have an output impedance between 0.5 Ohm and 1 Ohm.

11. Device according to claim 10, wherein the PMOS performance transistors (PMOSP) have a channel length greater than or equal to 0.72 micrometres.

12. Device according to any one of claims 1 to 11, wherein said at least one NMOS functionality transistor (NMOSF) has an output impedance between 5 Ohm and 10 Ohm.

13. Device according to claim 12, wherein said at least one NMOS functionality transistor (NMOSF) has a channel length greater than or equal to 1.44 micrometres.

14. Device according to any one of claims 1 to 13, wherein said at least one PMOS functionality transistor (PMOSF) has an output impedance between 5 Ohm and 10 Ohm.

15. Device according to claim 14, wherein said at least one PMOS functionality transistor (PMOSF) has a channel length greater than or equal to 1.44 micrometres.
